# EUROPEAN PATENT APPLICATION

(11) **EP 4 120 019 A1**
(43) Date of publication of application: **18.01.2023**
(21) Application number: 21185145.6
(22) Date of filing: 12.07.2021
(51) Int. Cl.: G03F 7/20, G01N 21/956, G03F 9/00, H01L 21/66

(54) **METHOD OF DETERMINING A CORRECTION FOR AT LEAST ONE CONTROL PARAMETER IN A SEMICONDUCTOR MANUFACTURING PROCESS**

(71) Applicant: ASML Netherlands B.V., 5500 AH Veldhoven (NL)
(72) Inventor: WERKMAN, Roy, 5500 AH Veldhoven (NL); ROY, Sarathi, 5500 AH Veldhoven (NL)
(74) Representative: ASML Netherlands B.V.

(57) **Abstract**

Described is a method and associated computer program and apparatuses for determining a correction for at least one control parameter, said at least one control parameter for controlling a semiconductor manufacturing process so as to manufacture semiconductor devices on a substrate. The method comprises: obtaining metrology data (MET, FP) relating to said semiconductor manufacturing process or at least part thereof; obtaining associated data (AD) relating to said semiconductor manufacturing process or at least part thereof, said associated data providing information for interpreting the metrology data; and determining said correction (PC) based on said metrology data and said associated data, wherein the determining is such that the determined correction depends on a degree to which a trend and/or event (DE!) in said metrology data should be corrected based on said interpretation of said metrology data.

## Description

### FIELD

The present invention relates to semiconductor manufacturing processes, in particular to methods of inspection or metrology in a semiconductor manufacturing process.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-ki lithography may be used to process features with dimensions smaller than the classical resolution limit of a lithographic apparatus. In such process, the resolution formula may be expressed as CD = k₁×λ/NA, where λ is the wavelength of radiation employed, NA is the numerical aperture of the projection optics in the lithographic apparatus, CD is the "critical dimension" (generally the smallest feature size printed, but in this case half-pitch) and k₁ is an empirical resolution factor. In general, the smaller k₁ the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k1.

These tight control loops are generally based on metrology data obtained using a metrology tool measuring characteristics of the applied pattern or of metrology targets representing the applied pattern. In general the metrology tool is based on optical measurement of the position and/or dimensions of the pattern and/or targets. It is intrinsically assumed that these optical measurements are representative for a quality of the process of manufacturing of the integrated circuits.

A process correction for an IC manufacturing process may be determined from metrology data of previously exposed wafers (the term wafer and substrate are used interchangeably and/or synonymously throughout this disclosure), so as to minimize any error in the metrology data of subsequently exposed wafers. However, it can be sometimes difficult to interpret the metrology data, i.e., the metrology data is not always representative of the best correction.

### SUMMARY

It is an object of the inventors to address the mentioned disadvantage of the state of the art.

In a first aspect of the invention there is provided a method of determining a correction for at least one control parameter, said least one control parameter for controlling at least part of a semiconductor manufacturing process so as to manufacture semiconductor devices on a substrate, the method comprising: obtaining metrology data relating to said semiconductor manufacturing process or at least part thereof; obtaining associated data relating to said semiconductor manufacturing process or at least part thereof, said associated data providing information for interpreting the metrology data; and determining said correction based on said metrology data and said associated data, wherein the determining is such that the determined correction depends on a degree to which a trend and/or event in said metrology data should be corrected based on said interpretation of said metrology data.

Also disclosed is a computer program and various apparatuses operable to perform the method of the first aspect.

### BRIEF DESCRIPTION OF THE DRAWINGS

Embodiments of the invention will now be described, by way of example only, with reference to the accompanying schematic drawings, in which:
Figure 1 depicts a schematic overview of a lithographic apparatus;
Figure 2 depicts a schematic overview of a lithographic cell;
Figure 3 depicts a schematic representation of holistic lithography, representing cooperation between three key technologies to optimize semiconductor manufacturing; and
Figure 4 illustrates schematically two known feedback control methods applied in a manufacturing facility.
Figure 5 is a simplified schematic flow diagram of part of an IC manufacturing method according to a known method;
Figure 6 is a plot of a control parameter value PV (or a metrology parameter value dependent on the control parameter) against time t for each of: (a) a positive jump/event and an Exponentially Weighted Moving Average (EWMA) temporal filtering method, (b) a positive jump/event and a neural network (NN) based temporal filtering method, (c) a negative jump/event and an EWMA temporal filtering method; and (d) a negative jump/event and a NN based temporal filtering method;
Figure 7 is a simplified schematic flow diagram of part of an IC manufacturing method according to a first embodiment of the invention;
Figure 8 shows equivalent plots as Figure 6, for the method illustrated by Figure 7;
Figure 9 is a simplified schematic flow diagram of part of an IC manufacturing method according to a second embodiment of the invention; and
Figure 10 shows equivalent plots as Figures 6 and 8, for the method illustrated by Figure 9.

### DETAILED DESCRIPTION

**In** the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate; the term "light valve" can also be used in this context. Besides the classic mask (transmissive or reflective; binary, phase-shifting, hybrid, etc.), examples of other such patterning devices include:
- a programmable mirror array. More information on such mirror arrays is given in U. S. Patent Nos. 5,296,891 and 5,523,193, which are incorporated herein by reference.
- a programmable LCD array. An example of such a construction is given in U. S. Patent No. 5,229,872, which is incorporated herein by reference.

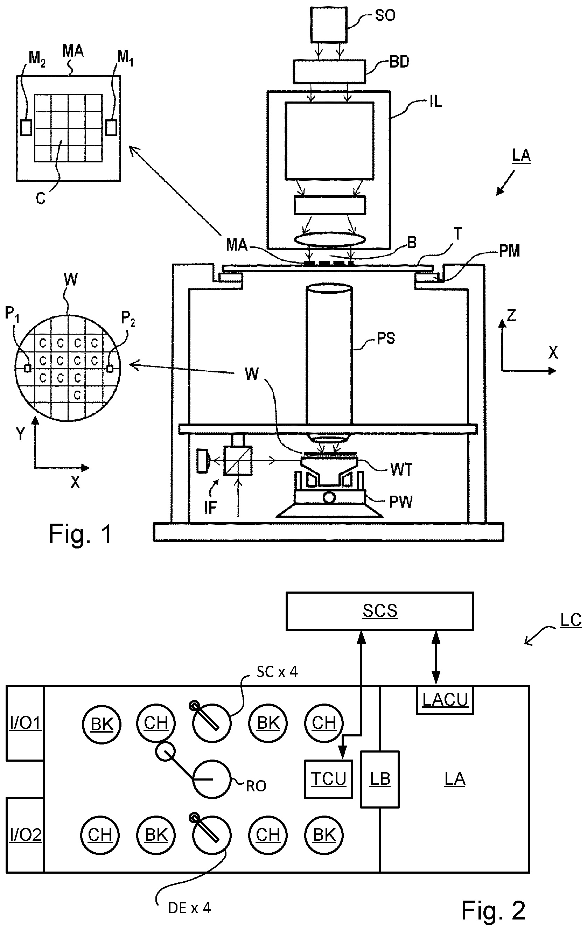

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a support structure (e.g., a mask table) MT constructed to support a patterning device (e.g., a mask) MA and connected to a first positioner PM configured to accurately position the patterning device MA in accordance with certain parameters, a substrate table (e.g., a wafer table) WT constructed to hold a substrate (e.g., a resist coated wafer) W and connected to a second positioner PW configured to accurately position the substrate in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illuminator IL receives a radiation beam from a radiation source SO, e.g. via a beam delivery system BD. The illumination system IL may include various types of optical components, such as refractive, reflective, magnetic, electromagnetic, electrostatic, or other types of optical components, or any combination thereof, for directing, shaping, or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and electrostatic optical systems, or any combination thereof, as appropriate for the exposure radiation being used, or for other factors such as the use of an immersion liquid or the use of a vacuum. Any use of the term "projection lens" herein may be considered as synonymous with the more general term "projection system" PS.

The lithographic apparatus may be of a type wherein at least a portion of the substrate may be covered by a liquid having a relatively high refractive index, e.g., water, so as to fill a space between the projection system and the substrate - which is also referred to as immersion lithography. More information on immersion techniques is given in U. S. Patent No. 6,952,253 and in PCT publication No. WO99-49504, which are incorporated herein by reference.

The lithographic apparatus LA may also be of a type having two (dual stage) or more substrate tables WT and, for example, two or more support structure MT (not shown). In such "multiple stage" machines the additional tables / structures may be used in parallel, or preparatory steps may be carried out on one or more tables while one or more other tables are being used for exposing the design layout of the patterning device MA onto the substrate W.

In operation, the radiation beam B is incident on the patterning device (e.g., mask MA), which is held on the support structure (e.g., mask table MT), and is patterned by the patterning device MA. Having traversed the mask MA, the radiation beam B passes through the projection system PS, which focuses the beam onto a target portion C of the substrate W. With the aid of the second positioner PW and position sensor IF (e.g., an interferometric device, linear encoder, 2-D encoder or capacitive sensor), the substrate table WT can be moved accurately, e.g., so as to position different target portions C in the path of the radiation beam B. Similarly, the first positioner PM and possibly another position sensor (which is not explicitly depicted in Figure 1) may be used to accurately position the mask MA with respect to the path of the radiation beam B. Mask MA and substrate W may be aligned using mask alignment marks M1, M2 and substrate alignment marks PI, P2. Although the substrate alignment marks as illustrated occupy dedicated target portions, they may be located in spaces between target portions (these are known as scribe-lane alignment marks).

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

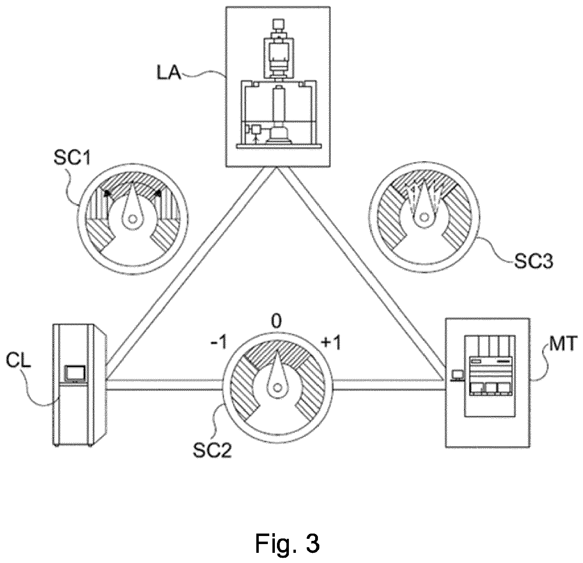

Typically the patterning process in a lithographic apparatus LA is one of the most critical steps in the processing which requires high accuracy of dimensioning and placement of structures on the substrate W. To ensure this high accuracy, three systems may be combined in a so called "holistic" control environment as schematically depicted in Figure 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - typically within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Figure 3 by the double white arrow in the first scale SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MT), so as to predict whether defects may be present due to e.g. sub-optimal processing (depicted in Figure 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Figure 3 by the multiple arrows in the third scale SC3).

The lithographic apparatus LA is configured to accurately reproduce the pattern onto the substrate. The positions and dimensions of the applied features need to be within certain tolerances. Position errors may occur due to an overlay error (often referred to as "overlay"). The overlay is the error in placing a first feature during a first exposure relative to a second feature during a second exposure. The lithographic apparatus minimizes the overlay errors by aligning each wafer accurately to a reference prior to patterning. This is done by measuring positions of alignment marks on the substrate using an alignment sensor. More information on the alignment procedure can be found in U.S. Patent Application Publication No. US20100214550, which is incorporated herein by reference. Pattern dimensioning (e.g., CD) errors may, for example, occur when the substrate is not positioned correctly with respect to a focal plane of the lithographic apparatus. These focal position errors may be associated with un-flatness of a substrate surface. The lithographic apparatus minimizes these focal position errors by measuring the substrate surface topography prior to patterning using a level sensor. Substrate height corrections are applied during subsequent patterning to assure correct imaging (focusing) of the patterning device onto the substrate. More information on the level sensor system can be found in U.S. Patent Application Publication No. US20070085991, which is incorporated herein by reference.

Besides the lithographic apparatus LA and the metrology apparatus MT other processing apparatus may be used during IC production as well. An etching station (not shown) processes the substrates after exposure of the pattern into the resist. The etch station transfers the pattern from the resist into one or more layers underlying the resist layer. Typically etching is based on application of a plasma medium. Local etching characteristics may, for example, be controlled using temperature control of the substrate or directing the plasma medium using a voltage controlled ring. More information on etching control can be found in international Patent Application Publication No. WO2011081645 and U.S. Patent Application Publication No. US 20060016561 which are incorporated herein by reference.

During the manufacturing of the ICs, it is of great importance that the process conditions for processing substrates using processing apparatus, such as the lithographic apparatus or etching station, remain stable such that properties of the features remain within certain control limits. Stability of the process is of particular importance for features of the functional parts of the IC, i.e., the product features. To guarantee stable processing, process control capabilities need to be in place. Process control involves monitoring of processing data and implementation of means for process correction, e.g. control the processing apparatus based on characteristics of the processing data. Process control may be based on periodic measurement by the metrology apparatus MT, often referred to as "Advanced Process Control" (further also referenced to as APC). More information on APC can be found in U.S. Patent Application Publication No. US20120008127, which is incorporated herein by reference. A typical APC implementation involves periodic measurements on metrology features on the substrates to monitor and correct drifts associated with one or more processing apparatus. The metrology features reflect the response to process variations of the product features.

In US20120008127, a lithographic apparatus is calibrated by reference to a primary reference substrate. Using an apparatus which need not be the same as the one being calibrated, there is obtained an apparatus-specific fingerprint of the primary reference substrate. Using the same set-up there is then obtained an apparatus-specific fingerprint of a secondary reference substrate. The apparatus-specific fingerprint of the primary reference substrate is subtracted from the apparatus-specific fingerprint of the secondary reference substrate to obtain and store an apparatus-independent fingerprint of the secondary reference substrate. The secondary reference substrate and stored apparatus-independent fingerprint are subsequently used together in place of the primary reference substrate as a reference for the calibration of the lithographic apparatus to be calibrated. Initial set-up for a cluster of lithographic tools can be performed with less use of the costly primary reference substrate, and with less interruption to normal production. The initial set-up can be integrated with ongoing monitoring and re-calibration of the apparatuses.

The term fingerprint may refer to a main (systematic) contributor ("latent factor") of a measured signal, and in particular a contributor connected to the performance impact on-wafer or to previous processing steps. Such a fingerprint can refer to substrate (grid) patterns (e.g. from alignment, leveling, overlay, focus, CD), field patterns (e.g., from intrafield alignment, leveling, overlay, focus, CD), substrate zone patterns (e.g., outermost radius of wafer measurements) or even patterns in scanner measurements related to wafer exposure (e.g., heating signature through-lot from reticle alignment measurements, temperature/pressure/servo profiles, etc.). Fingerprints may be comprised within a fingerprint collection, and may be encoded homogenously or heterogeneously therein.

As such, APC identifies correctable variation in a performance parameter such as overlay, and applies one set of corrections to a lot (batch) of wafers. In determining these corrections, corrections from previous lots are taken into account in order to avoid overcorrecting the noise in the measurements. For adequate smoothing of current corrections with previous ones, the history of corrections taken into account may match the context of the current lot. "Context" in this regard encompasses any parameters that identify variants arising within the same overall industrial process. The layer ID, layer type, product ID, product type, reticle ID and so forth are all context parameters that may lead to different fingerprints in the finished performance. In addition to the individual scanners that may be used in a high-volume manufacturing (HVM) facility, the individual tools used for each of the coating, etching, and other steps involved in semiconductor manufacturing can also vary from lot to lot or wafer to wafer. Each of these tools can impose a particular error "fingerprint" on the products. Outside the field of semiconductor manufacturing, similar situations may arise in any industrial process.

To ensure accurate feedback control appropriate to the particular context, different lots (batches) of product units can be treated as separate "threads" in the APC algorithms. Context data can be used to assign each product unit to the correct thread. In the case of a manufacturing plant producing usually high volumes of only a few types of products by the same process steps, the number of different contexts may be relatively small, and the number of product units in each thread will be ample to allow smoothing of noise. All of the lots having a common context can be assigned to their own thread to optimize the feedback correction and the ultimate performance. In case of a foundry producing many different types of product in very small production runs, the context may change more often, and the number of lots having exactly the same context data may be quite small. Using only the context data to assign lots to different APC 'threads' may then result in a large number of threads, with a small number of lots per thread. Complexity of the feedback control increases, and the ability to improve performance for low-volume products is reduced. Combing different lots into the same threads without sufficient regard to their different contexts will cause loss of performance also.

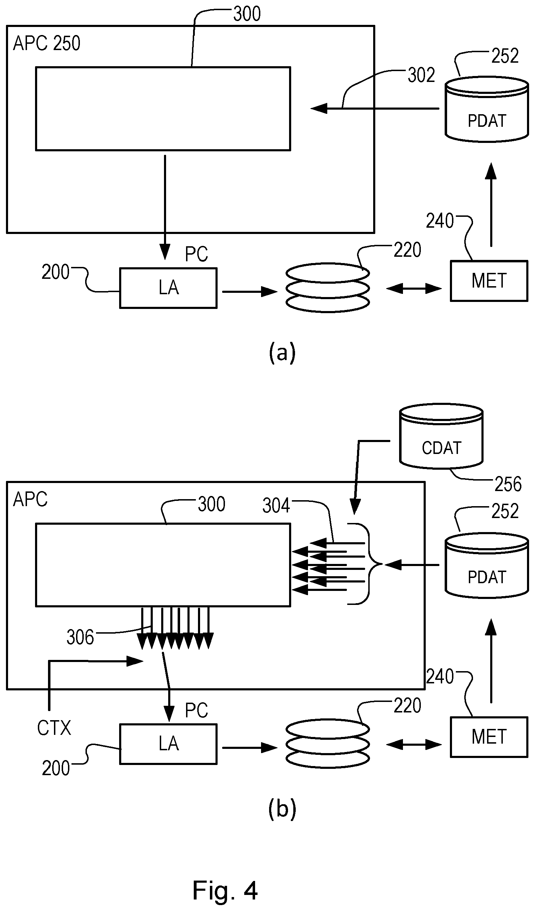

Figure 4 (a) illustrates schematically the operation of one type of control method implemented by APC system 250. Historic performance data PDAT is received from the storage 252, having been obtained by metrology apparatus 240 or other means from wafers 220 that have been processed by lithographic apparatus 200 and associated apparatuses of the lithocell. A feedback controller 300 analyzes the performance parameters represented in the performance data for recent lots, and calculates process corrections PC which are fed to the lithographic apparatus 200. These process corrections are added to the wafer-specific corrections derived from the alignment sensors and other sensors of the lithographic apparatus, to obtain a combined correction for the processing of each new lot.

Figure 4 (b) illustrates schematically the operation of another type of control method implemented by a known APC system 250. As can be seen, the general form of the feedback control method is the same as that shown in Figure 4 (a), but in this example, context data relating to the historic wafers and context data CTX relating to the current wafer is used to provide a more selective use of the performance data PDAT. Specifically, while in the earlier example the performance data for all historic wafers was combined in a single stream 302, and the modified method, context data from storage 256 used to assign the performance data for each historic lot to one of several threads 304. These threads are processed effectively in parallel feedback loops by feedback controller 300, yielding multiple process corrections 306, each based on the historic performance data of wafers in one of the threads 304. Then, when new lots are received for processing, their individual context data CTX can be used to select which of the threads provides the appropriate context data 306 for the current wafer.

There are a number of alternative methods for temporal processing and/or filtering of (feedback) control data (e.g. overlay fingerprints or EPE fingerprints). Such methods include using a moving average processing method; e.g., a weighted moving average or Exponentially Weighted Moving Average EWMA. Other methods include a machine learning model such as a Neural Network (NN). For example, an advanced NN filtering method may be trained to learn the appropriate response to temporal behavior based on historic control parameter data and provide a (feedback) correction prediction for the next lot, e.g. in an APC control loop.

A disadvantage of these existing methods is that the temporal processor (e.g., NN or EWMA filter) "learns" based only on the behavior of the control parameters, as can be determined from metrology data of exposed structures. Measured parameter values (e.g., overlay, edge placement error, critical dimension, focus) in the metrology data vary with changes in behavior over time of these control parameters (i.e., a different output is measured for the same control input). Control parameters may be any input parameters of the scanner or other tool used in IC manufacture (e.g., etch chamber, deposition chamber, bonding tool etc.) which control the manufacturing process (e.g., exposure process, etch process, deposition process, bonding process etc.). Therefore, control of the output process, more specifically the formation, configuration and/or positioning of the exposed and/or etched structures, is dependent on these control parameters. As such, it is these control parameters which may be controlled to correct or compensate for any measured error in the metrology data, either in a feedback loop to correct future wafers/lots or as a feedforward correction to correct a present wafer/lot. Note than "learning" in this context includes averaging in a moving average example, as the moving average output effectively "learns" (in a loose sense) to respond to inputted data by averaging the data (its output response changes over time based on the previous few inputs).

The APC control loop described above has a primary task of monitoring drift in metrology data indicative of drift of the control parameter behavior and determining appropriate corrections for the control parameters to address this drift and maintain the measured metrology parameter values within specification (i.e., within a certain acceptable tolerance or "process window") within which the IC device can be expected to function with good probability.

However, not all drift in the metrology data should be corrected for (or followed), only drift in actual parameters of the product features which results from control parameter behavior drift (real drift). Other sources of drift in the metrology data may be caused, for example, metrology tool drift, or metrology target imperfections (e.g., fingerprints introduced by overlay target deformation) which are not replicated in the product structure (metrology targets, due to their larger size, can behave differently to product structure when being imaged and/or measured). These drifts are not "real", i.e., they are not actually indicative of drift in the exposure (or other processing) process affecting the product structure quality. A metrology tool which has drifted and measures less accurately resulting in out-of-spec metrology parameter values does not mean, of course, that the product on wafer is out of spec; therefore this metrology tool drift should be ignored by the APC loop. Also, alignment mark deformation may induce a drift which can be captured by the APC loop, which should not be followed.

As well as (e.g., relatively steady) drifts, the metrology data may indicate a "jump" or "step" in the process, e.g., a sudden, relatively large change in the measured parameter values indicative of a more sudden change in control behavior. As with drift, such jumps may be indicative of something that should be followed and corrected for, or alternatively something that should be ignored. A specific example of a jump being indicative of something that should be followed is when a calibration state of the scanner is changed. This may, for example, manifest as a jump in magnification. This change in state should be incorporated in an updated feedback control, because the change is permanent. By contrast, a scanner lens may be subject to a lens "hiccup" or transient lens jump which may also manifest itself as a jump in magnification. However, such a lens hiccup is a one-time deviation and should not be followed by the feedback control as it will not be present in the next lot.

The APC controller has no way of knowing which drifts and/or jumps should be acted upon and which should be ignored based on the metrology data alone, as these different types of drifts and jumps are indistinguishable within the metrology data; i.e., a lens hiccup and a calibration state jump will look the same in the metrology data. More specifically, a neural network used as a temporal filter can be trained to learn how to respond to certain trends or events (e.g., drifts and/or jumps). However, without any knowledge of the underlying reasons for these effects, a neural network based control system cannot be sure to respond appropriately (e.g., follow, ignore or partially follow/partially ignore (e.g., according to an appropriate non-binary weighting).

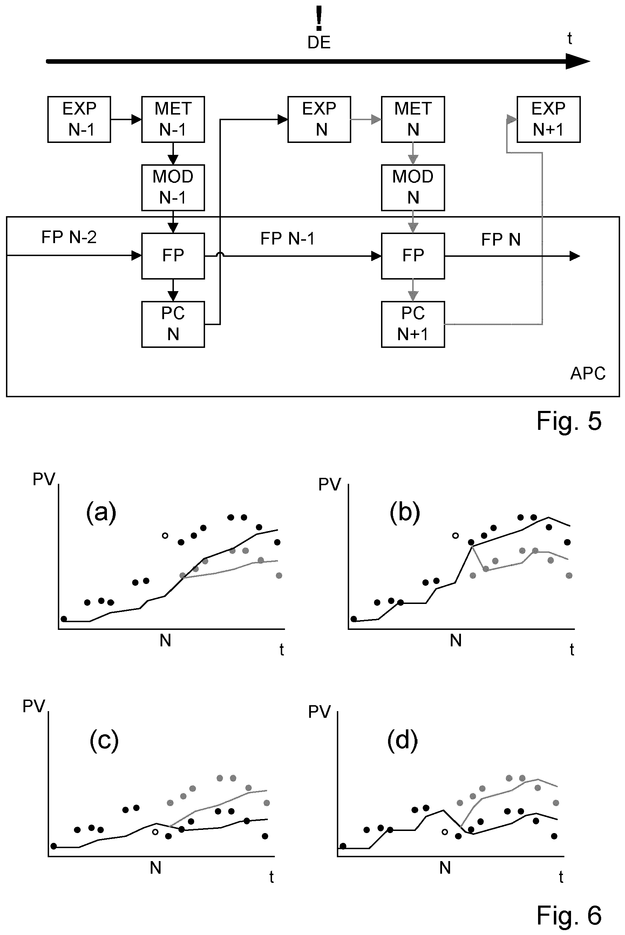

Figure 5 is a flow diagram of (e.g., part of) an IC manufacture process, relating to exposure, metrology and APC control of the process for a number of wafer lots. The example is abbreviated and may include etch steps, deposition steps, wafer bonding steps etc. depending on the specific process. Time t is shown as traveling left to right. An exposure of lot N-1 EXP N-1 is performed and then measured MET N-1. A modeling step MOD N-1 is performed to fit a model to the metrology data, e.g., such that the metrology data can be described more efficiently. Within the APC controller, a filtered fingerprint FP is determined (i.e., based on the modeled metrology data and the fingerprint from at least the previous lot FP N-2, and possibly additional data (e.g., from other lots) if a NN is used as the temporal filter). Based on this fingerprint, a process correction PC N for the next lot (lot N) is determined). While the metrology, modeling, fingerprint and correction determination steps are shown as occurring simultaneously, they of course cannot literally do so, only effectively within the context of the flow shown. Following this, exposure of lot N EXP N is performed using the determined corrections PC N. However, at the time of this exposure, a disturbing event DE occurs, e.g., which may manifest as a jump in the metrology data MET N. The remainder of the flow is the same as for lot N-1, but the gray arrows indicate that this flow and the modeled data MOD N, fingerprints and corrections for the next lot PC N+1 will be impacted by the disturbing event DE.

Figure 6 illustrates how a control parameter might follow the data according to a control strategy, depending on whether a jump or disturbing event is real or false/a one-time event. Each plot is a plot of a control parameter value PV or a metrology parameter value (e.g., overlay) dependent on the control parameter against time (or lot). In each plot, each point up to lot N represents a value for that lot. The point for lot N (represented as a white circle) is indicative of a jump (positive jump in Figures 6(a) and 6(b) and a negative jump in Figures 6(c) and 6(d). Beyond that, each lot is represented by two points: a first point (black) representing what would be expected to be seen if the jump was real, and a second point (gray) representing what would be expected to be seen if the jump was false/one-time event. The line represents a control signal correction as might be determined by the APC loop based on the metrology points. Again, after lot N, there are two lines, a black line following the black points and a gray line following the gray points. The distance between the control signal correction (line) and the corresponding control parameter point is indicative of the control performance; the closer the line is to a corresponding point, the better the correction and control performance.

Figure 6(a) shows a positive jump and an EWMA based control. The EWMA is slow in following a real jump. A hiccup (in this one example) actually helps the control, as it reduces the control lag (the gray line for lot N+1 is much closer to the parameter value than it would be if no jump occurred). Figure 6(b) shows a positive jump and a NN based control. The NN is better at following the corrections, and follows the real jump well, assuming it has been trained to do so. It also mistakes the hiccup for a real jump, which means that, in the hiccup case, lot N+1 could well be exposed out-of-spec. This could also be the other way around depending on how the NN is trained; i.e., if it were trained to ignore a jump and assume it a hiccup, or somewhere in between (e.g., when it has been trained about both and may respond with an intermediate correction). Figures 6(c) and 6(d) show equivalent plots to Figures 6(a) and 6(b) respectively, with a negative jump. Comparing Figure 6(c) to Figure 6(a), it is now apparent that a negative hiccup (false jump) in this example harms the control significantly for a number of future lots.

To address the issues raised, it is proposed that the temporal data processor receives associated data in addition to metrology data from previously exposed wafers, the associated data comprising information about temporal behavior of effects and/or events related to the one or more control parameters.

Associated data in this respect may comprise data which is not dependent or not directly dependent on the control parameter(s) being corrected/controlled using the methods disclosed herein. For example associated data may comprise data which is not directly measured from previously exposed/processed wafers. However, associated data may include data that is dependent on the control parameter(s) being corrected and/or data directly measured from previously exposed/processed wafers (e.g., different types of metrology data). In either case, the associated data in the context of this disclosure is distinguished from the metrology data in that it is used only to interpret the metrology data and is not actively corrected for; i.e., the determined correction is not determined or optimized for correcting the associated data (although of course it may happen to correct/improve this data e.g., where the associated data comprises a different type of metrology data).

As such, disclosed herein is a method for determining a correction for at least one control parameter, said at least one control parameter for controlling a semiconductor manufacturing process so as to manufacture a substrate. The method comprises: obtaining metrology data relating to said semiconductor manufacturing process or at least part thereof; obtaining associated data relating to said semiconductor manufacturing process or at least part thereof, said associated data providing information for interpreting the metrology data; and determining said correction based on said metrology data and said associated data wherein said associated data is used to interpret said metrology data.

One difference between the proposed method and a 'rework decision maker', which is a known concept, is that the associated data controller intervenes before the exposure or other manufacturing step is performed, while the rework decision maker acts after the exposure or other manufacturing step.

In this way, the at least one control parameter is coupled to said associated data such that a temporal data processor used to process the metrology data also receives as an input from associated data that is not controlled itself (e.g., not directly dependent on the control parameter(s)), but that provides information on how to interpret and/or respond to the metrology data.

When the temporal data processor is embodied in a machine learning model such as, for example, a neural network, causal convolution filter or long short-term model (LSTM), the machine learning model may be trained and/or updated using metrology data and the associated data such that the machine learning model learns how to interpret the metrology data based on the associated data.

For physics-based models or embodiments where the temporal data processor comprises a weighted moving average determination (e.g., EWMA), the temporal data processor may comprise additional logic to process the associated data and implement basing dependency of the correction on how the metrology data is interpreted. For example, in the case of the weighted moving average, the additional logic may comprise a control routine which interprets the associated data and varies a weighting parameter of the moving average based on the associated data.

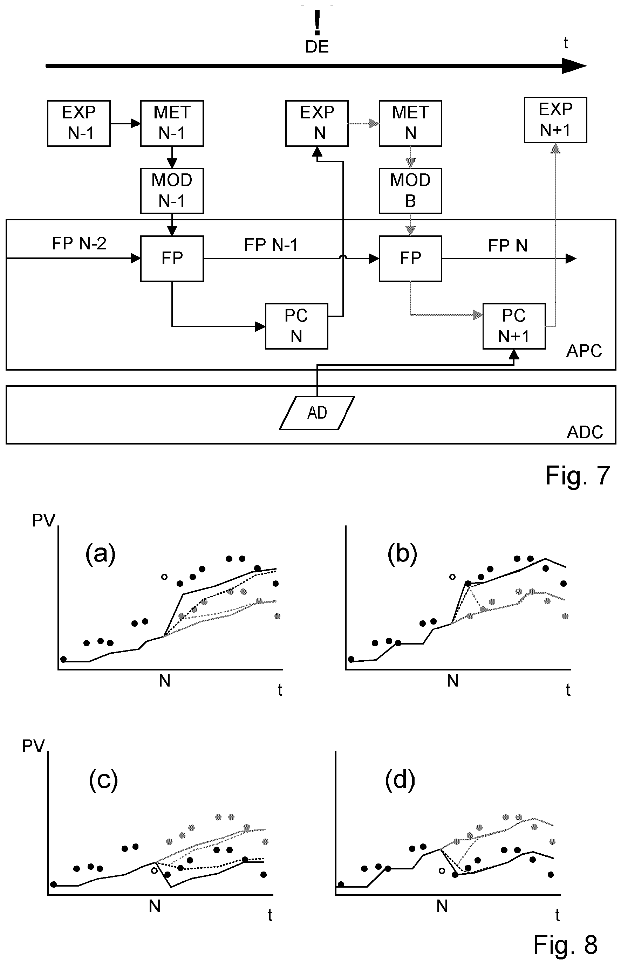

Figure 7 is an equivalent flow diagram to that of Figure 5, but incorporates the concepts disclosed. Many of the steps are the same as that of Figure 5 and will not be described again. The main difference is the associated data collector ADC which collects associated data AD. In this example, it has collected associated data AD which is related to (and indicative of) the disturbing event DE. Based on the associated data AD, the APC controller can better interpret the metrology data MET N when determining the correction for the next lot PC N+1.

Figures 8(a)-(d) show equivalent plots to Figures 6(a)-(d) respectively, but where the method described by Figure 7 has been implemented. In each case the dotted lines (after the disturbing event/lot N) are the control signal corrections of the equivalent plot of Figure 6, shown for comparison. In each case, it is apparent that the control is improved, particularly for lot N+1.

Associated data can comprise any data from which an inference on a cause of an event/trend in metrology data can be made. Such associated data may comprise, for example, one or more of: alignment data, leveling data, tool usage data (e.g., how long a tool has been used for continuously, or since a calibration and/or maintenance action etc.), scanner exposure data (e.g., lens control parameter data), calibration/maintenance reports/logs, tool logging data, mark or target deformation data, other types of metrology data (e.g., critical dimension data, after-etch overlay data), previous layer (control) data (an effect/event occurring at and corrections applied to the previous layer will also have impact on the current layer corrections; for example it may be that a jump in the previous layer may have to be followed in the current layer). Many of these examples, where appropriate, may relate to any tool used in the manufacturing process or an associated metrology tool.

Using a specific example of tool usage data, it can be shown that drift depends on how long a certain tool is used (e.g., how long an etcher has been etching or how long a wafer table has been in use). Drift will usually show the same behavior over time; e.g., it is typically possible to predict drift (e.g., by extrapolation) from the tool usage data time and as such any observed drift in the metrology data which resembles this predicted drift may be assumed to be real drift to be followed. For example, cumulative etcher time per chamber may be used in combination with other associated data, e.g., etch settings and internal etcher corrections, to determine the magnitude of the chamber drift.

It should be noted that the corrections may be determined not only for the scanner, but also (in addition or alternatively) to other process tools (e.g. etcher, deposition tool, polish tool, wafer bonding tool) of the manufacturing process. As such, a correction may be implemented by a single tool (e.g., scanner, etcher, deposition tool, polish tool, bonding tool) or a (e.g., co-optimized) correction may be split across two or more tools (e.g., overlay or edge placement error correction may be implemented through co-optimized correction to both scanner and etcher).

Using some of the specific examples given previously, a lens hiccup may be identified, by example, from machine behavior data which tracks machine behavior. For example, such machine behavior data may comprise lens control parameters. By feeding the associated data into the control loop, the temporal processor (e.g., a NN) can learn which machine behavior data values are indicative of a hiccup and interpret the metrology data accordingly, for example.

Changes in calibration or a maintenance action can be identified from an associated calibration report or maintenance report. Any calibration or maintenance action will result in a calibration report identifying the applied change. Using the calibration reports, the system can learn their impact on control and how to interpret the metrology data accordingly.

With respect to drift, in the absence of false/one-off jumps and false drifts, the drift can be expected to be well followed by the feedback mechanism used presently (present APC loop) as this is a main function of APC. To interpret the metrology data in the presence of false/one-off jumps and false drifts, example associated data may comprise (for example) offline metrology tool report data from the offline metrology tool(s) used to measure the metrology data, or metrology tool usage data or anything else which a change in accuracy of the metrology tool may be determined. Such metrology tool report data may comprise, for example, one or more measurement key performance indicators (KPIs) such as after-etch metrology data. Such associated data or a combination thereof can be used to identify false metrology induced drifts or shifts.

In another example, different alignment channels in alignment data may yield mark deformation data which can be used as associated data, as such mark deformation may look like process drift in the metrology data (i.e., it comprises false (metrology) drift).

It should be noted that the metrology data may describe spatial behavior (e.g., as described by a spatial representation or fingerprint FP, such as an overlay fingerprint).

Figures 7 an 8 relate to an example where the response *a posteriori* (i.e., only after another metrology step will the system know whether an event or trend was real or not.). More specifically, the disturbing event occurred just before or during lot N, but its effect had to be measured MET N after exposure and development of lot N, so that the appropriate correction cannot be implemented till lot N+1. This may result in lot N being out of spec and requiring rework which is clearly undesirable.

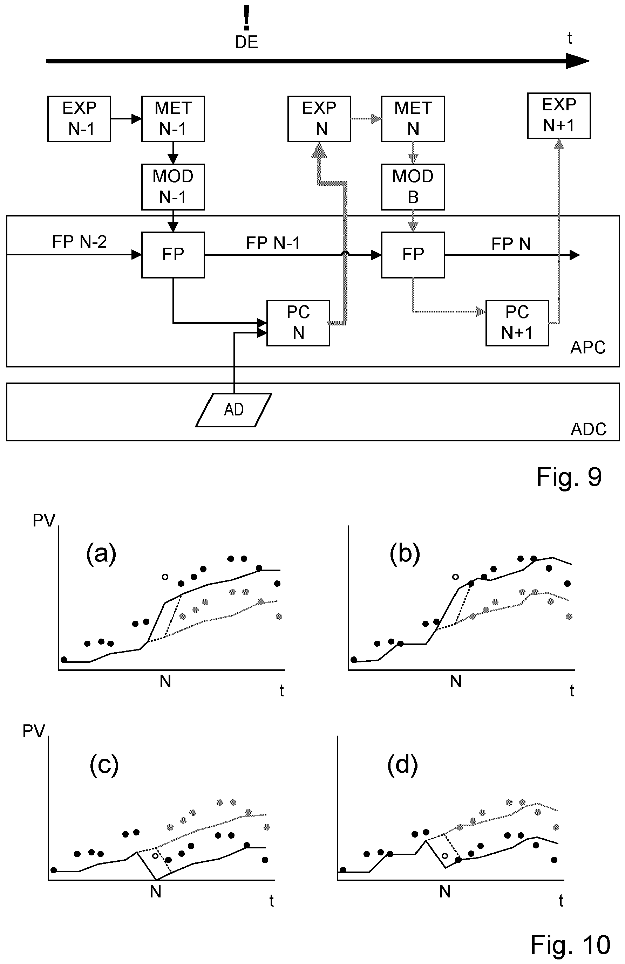

Figure 9 and 10 relate to a second embodiment, where the feedback control is combined with a feedforward element. Figures 10(a)-(d) show equivalent plots to Figures 8(a)-(d) respectively, but where the method described by Figure 9 has been implemented. Figure 9 is an equivalent flow diagram to that of Figures 5 and 7. Many of the steps/elements are the same as that of Figure 5 and Figure 7 and will not be described again.

A difference in this embodiment is that the disturbing event DE has occurred slightly earlier, before exposure of lot N EXP N. Because of this, the appropriate associated data AD can be used by the APC controller to determine a correction PC N for the exposure of lot N EXP N. Note that this correction is determined before the effect of the disturbing event is measured via the step of lot N metrology MET N. As such, this embodiment comprises a predictive element, where the effect of the disturbing event DE is predicted from the associated data and the correction determined at step PC N is determined to also correct for this predicted effect, if indeed it is an event which should be followed; the method still uses the associated data to interpret the event as before..

This predictive element may also be implemented within a lot, such that the predicted effect may be corrected for remaining wafers of a lot, or remaining fields of a wafer, e.g., should the event happen or be detected from the associated data during the lot processing or a wafer exposure respectively.

Using a NN or other machine learning example, the system may have learned how certain events, for example a change in calibration state, will impact control behavior and therefore can identify a required correction based on the predicted impact and the interpretation of the event before exposure of the applicable lot. This means that the corrections for a certain lot will have to be made just-in-time, so that any last minute effects can be taken into account. This could even be during lot streaming, in between wafer exposures or during a wafer exposure, between field exposures. It can be appreciated in this embodiment (unlike the previous embodiments), that events interpreted as real but one-off events (e.g., a lens hiccup) rather than false events can now be corrected for appropriately for the present lot only (e.g., the APC loop can interpret the correction as a one-time correction, such that the event is then ignored for correction of lots subsequent to the present lot).

It should be appreciated that the metrology data used in the methods described herein may comprise synthetic metrology data (alternatively or in combination with non-synthetic metrology data measured from one or more physical wafers), e.g., as obtained via computational lithography techniques which simulate one or more steps of a semiconductor manufacturing process.

The proposed method may improve control accuracy, the impact of a change in calibration state, and so-called "c-time" or machine idle time. It is typical to reduce usage of a machine that is planned for maintenance because of possible impact on critical layers.

The concepts disclosed herein may be extended to impose a shared learning across process threads which have some overlap; e.g., different threads running on the same scanner can learn from each other, speeding up the learning process. For example, if the metrology data from a scanner shows a jump/event in one thread, this learning can be shared as associated data; e.g., the metrology data from this thread may be used as associated data to interpret metrology data for another thread.

A main benefit will be seen when the relation between the occurring effects and the parameter effect is not directly predictable; i.e., it requires training and therefore will benefit from a machine learning (e.g., NN) implementation taking all associated data into account. Another benefit is in the machine learning model having both associated data and metrology measurements (e.g. overlay) from which other parameters can be modeled. That will strengthen any learning of the behavior of certain effects. For example, if the effect is seen in a certain combination of parameters, then it is easier to identify a root cause.

By way of a specific example of where metrology data interpretation using associated data may be useful is after wafer table reconditioning. After wafer table reconditioning there is always a drift in the fingerprint as the on-product overlay resets to good wafer table condition. A drift in the top layer may be observed while the bottom layer may have already been exposed with a good wafer table and hence does not see any fingerprint change (or *vice versa).* The additional data inputted to the APC loop, e.g., from leveling, can make the APC controller aware of this. Additionally, since there are additional measurements in the scanner which are sensitive to mark deformation, they can also be used in the control loop to make it aware of 'fake' corrections.

Further embodiments are disclosed in the list of numbered clauses below:
1. A method of determining a correction for at least one control parameter, said least one control parameter for controlling at least part of a semiconductor manufacturing process so as to manufacture semiconductor devices on a substrate, the method comprising: obtaining metrology data relating to said semiconductor manufacturing process or at least part thereof; obtaining associated data relating to said semiconductor manufacturing process or at least part thereof, said associated data providing information for interpreting the metrology data; and determining said correction based on said metrology data and said associated data wherein said associated data is used to interpret said metrology data.
2. A method according to clause 1, wherein the determining step is such that the determined correction depends on a degree to which a trend and/or event in said metrology data should be corrected based on said interpretation of said metrology data.
3. A method according to clause 1 or 2, wherein the determining step comprises determining whether a trend and/or event in said metrology data should be ignored or corrected for.
4. A method according to any preceding clause, wherein the determining step further comprises determining a non-binary weighting for the metrology data depending on said interpretation of the metrology data.
5. A method according to any preceding clause, wherein said metrology data comprises one or more of overlay data, focus data, critical dimension data and edge placement error data.
6. A method according to any preceding clause, wherein the step of determining a correction comprises the steps of modeling the metrology data and determining a spatial representation of the modeled metrology data, said correction being determined based on the spatial representation of the modeled metrology data.
7. A method according to any preceding clause, comprising temporally filtering said metrology data; and wherein said associated data is used to interpret said metrology data as part of said temporally filtering step.
8. A method according to clause 7, wherein said temporal filtering step comprises applying a weighted moving average to said metrology data.
9. A method according to clause 8, comprising processing said associated data to interpret said metrology data; and varying a weighting of said weighted moving average based on said processing.
10. A method according to clause 7, wherein said temporal filtering step is performed using a trained machine learning model.
11. A method according to clause 10, wherein the machine learning model is a neural network, causal convolution filter or long short-term model.
12. A method according to clause 10 or 11, comprising training said machine learning model to interpret said metrology data based on said associated data.
13. A method according to any preceding clause, wherein said correction is determined for application to one or more subsequent lots of substrates.
14. A method according to any of clauses 1 to 12, wherein said correction is determined for application to a present lot and/or to a present wafer as a feedforward correction.
15. A method according to clause 14, wherein said correction is determined to be applied before processing of said present lot and/or present wafer.
16. A method according to clause 14, wherein said correction is determined to be applied during processing of said present lot and/or present wafer.
17. A method according to clause 14, 15 or 16 comprising using said associated data to predict the effect that a trend and/or event indicated in the associated data has on behavior of said at least one control parameter.
18. A method according to any preceding clause, wherein said at least one control parameter relates to a control parameter of one or more of: an exposure step, an etch step, a deposition step, a polish step, a metrology step or a bonding step, of said semiconductor manufacturing process on said substrate.
19. A method according to any preceding clause, wherein said associated data comprises data used only to interpret the metrology data and is not actively corrected for in said determining step.
20. A method according to any preceding clause, wherein said associated data comprises one or more of: alignment data, leveling data, tool usage data, lithographic exposure data, lens control parameter data, calibration/maintenance reports/logs, tool logging data, mark or target deformation data, additional metrology data of a different type to said metrology data and/or relating to a different process thread, previous layer control and/or metrology data, said associated data relating to one or more tools used in and/or processes of said semiconductor manufacturing process.
21. A method according to any preceding clause, wherein said metrology data relates to metrology of one or more previous substrates, said one or more previous substrates having been previously subject to said semiconductor manufacturing process or at least part thereof.
22. A method according to clause 21, wherein said associated data relates to said one or more previous substrates and/or a tool or process used on said previous substrates.
23. A method according to clause 21 or 22, further comprising measuring said one or more previous substrates to obtain said metrology data.
24. A method according to any preceding clause, wherein said metrology data comprises synthetic metrology data from a simulation of said semiconductor manufacturing process or at least part thereof.
25. A computer program comprising program instructions operable to perform the method of any of clauses 1 to 20, when run on a suitable apparatus.
26. A non-transient computer program carrier comprising the computer program of clause 25.
27. A processing system comprising a processor and a storage device comprising the computer program of clause 25.
28. A lithographic apparatus arrangement comprising: a lithographic exposure apparatus; and the processing system of clause 27.
29. A lithographic cell comprising: the lithographic apparatus arrangement of clause 28; and
a metrology device comprising the processing system of clause 27 and further operable to perform the method of clause 20.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A method of determining a correction for at least one control parameter, said at least one control parameter for controlling at least part of a semiconductor manufacturing process so as to manufacture semiconductor devices on a substrate, the method comprising:
obtaining metrology data relating to said semiconductor manufacturing process or at least part thereof;
obtaining associated data relating to said semiconductor manufacturing process or at least part thereof, said associated data providing information for interpreting the metrology data; and
determining said correction based on said metrology data and said associated data, wherein the determining is such that the determined correction depends on a degree to which a trend and/or event in said metrology data should be corrected based on said interpretation of said metrology data.

2. A method as claimed in claim 1, wherein the determining step comprises determining whether a trend and/or event in said metrology data should be ignored or corrected for.

3. A method as claimed in any preceding claim, wherein the determining step further comprises determining a non-binary weighting for the metrology data depending on said interpretation of the metrology data.

4. A method as claimed in any preceding claim, wherein said metrology data comprises one or more of overlay data, focus data, critical dimension data and edge placement error data.

5. A method as claimed in any preceding claim, wherein the step of determining a correction comprises modeling of the metrology data and determining a spatial representation of the modeled metrology data, said correction being determined based on the spatial representation of the modeled metrology data.

6. A method as claimed in any preceding claim, comprising temporally filtering said metrology data; and wherein said associated data is used to interpret said metrology data as part of said temporally filtering step.

7. A method as claimed in claim 6, wherein said temporal filtering step comprises applying a weighted moving average to said metrology data.

8. A method as claimed in claim 7, comprising processing said associated data to interpret said metrology data; and
varying a weighting of said weighted moving average based on said processing.

9. A method as claimed in claim 6, wherein said temporal filtering step is performed using a trained machine learning model.

10. A method as claimed in claim 9, wherein the machine learning model is a neural network, causal convolution filter or long short-term model.

11. A method as claimed in claim 9 or 10, comprising training said machine learning model to interpret said metrology data based on said associated data.

12. A method as claimed in any preceding claim, wherein said correction is determined for application to one or more subsequent lots of substrates.

13. A method as claimed in any preceding claim, wherein said at least one control parameter relates to a control parameter of one or more of: an exposure step, an etch step, a deposition step, a polish step, a metrology step or a bonding step, of said semiconductor manufacturing process on said substrate.

14. A method as claimed in any preceding claim, wherein said associated data comprises one or more of: alignment data, leveling data, tool usage data, lithographic exposure data, lens control parameter data, calibration/maintenance reports/logs, tool logging data, mark or target deformation data, additional metrology data of a different type to said metrology data and/or relating to a different process thread, previous layer control and/or metrology data, said associated data relating to one or more tools used in and/or processes of said semiconductor manufacturing process.

15. A method as claimed in any preceding claim, wherein said metrology data comprises synthetic metrology data from a simulation of said semiconductor manufacturing process or at least part thereof.
